# EUROPEAN PATENT APPLICATION

(11) **EP 4 797 110 A1**
(43) Date of publication of application: **26.08.2026**
(21) Application number: 24879115.4
(22) Date of filing: 18.10.2024
(51) Int. Cl.: G06F 16/22

(54) **METHOD AND APPARATUS FOR GENERATING ELECTRICAL TOPOLOGICAL RELATIONSHIP DIAGRAM OF POWER SYSTEM, AND MEDIUM**

(30) Priority: 19.10.2023 CN 202311365275
(71) Applicant: Hoymiles Power Electronics Inc., Hangzhou, Zhejiang 310015 (CN)
(72) Inventor: YU, Hongbin, Hangzhou, Zhejiang 310015 (CN); LI, Jun, Hangzhou, Zhejiang 310015 (CN); WANG, Jingming, Hangzhou, Zhejiang 310015 (CN); ZHAO, Yi, Hangzhou, Zhejiang 310015 (CN); YANG, Bo, Hangzhou, Zhejiang 310015 (CN)
(74) Representative: Petraz, Gilberto Luigi
(86) International application number: PCT/CN2024/125737
(87) International publication number: WO 2025/082475

(57) **Abstract**

A method and an apparatus for generating an electrical topology diagram of a power system, and a medium are provided. The method includes identifying at least one information identification diagram corresponding to each of the at least one convergence device to obtain electrical topology location information and device information of power devices connected to each of the at least one convergence device; and generating an electrical topology diagram of the power system based on the electrical topology location information and the device information of the power devices connected to each of the at least one convergence device. The information identification diagram includes at least one cell, and each of the at least one cell has a device identifier of corresponding one of the plurality of power devices and electrical topology location information of the one of the plurality of power devices.

## Description

### CROSS-REFERENCE TO RELATED APPLICATION

This application claims priority to Chinese patent application No. 202311365275.0, filed on October 19, 2023, and titled "METHOD AND APPARATUS FOR GENERATING ELECTRICAL TOPOLOGY DIAGRAM OF POWER SYSTEM, AND MEDIUM". The content of the above identified application is hereby incorporated herein in its entirety by reference.

### TECHNICAL FIELD

The present invention relates to the field of power electronics, and in particular, to a method and an apparatus for generating an electrical topology diagram of a power system, and a medium.

### BACKGROUND

With the development of power electronics technology, the application of power devices in a power system has become increasingly common. A power device is connected to a direct current (DC) power supply to implement functions such as power optimization, monitoring, and rapid shutdown. The power device mainly includes a microinverter, a shutdown device, a power optimizer, and a monitor. The DC power supply can be a photovoltaic DC power supply, a fuel cell, or an energy storage battery.

Generally, one or more DC power supplies are configured with one power device, and a plurality of power devices are connected in parallel or in series to form a group of power devices, which is then connected to a convergence device. The convergence device may be an alternating current (AC) convergence box, a DC convergence box, or a string inverter. Exemplarily, in a typical 100 kW distributed photovoltaic system, there may be 8 to 16 power devices, 50 to 300 power devices, and 200 to 300 photovoltaic components. When an abnormality occurs in a power device or a DC power supply, in order to quickly locate a fault position and improve troubleshooting efficiency, it is necessary to obtain an electrical topology diagram of a power system, including which group of power devices each power device belongs to, a ranking of the power device in the group of power devices, and serial numbers of a convergence device and a port to which the group of power devices is connected. However, currently there is no simple and easy-to-operate method to obtain the electrical topology diagram of the power system.

### SUMMARY

According to various embodiments of the present invention, a method and an apparatus for generating an electrical topology diagram of a power system, and a medium are provided.

In a first aspect, a method for generating an electrical topology diagram of a power system is provided in an embodiment of the present invention. The power system includes a plurality of direct current (DC) power supplies, a plurality of groups of power devices, and at least one convergence device. Each of the plurality of groups of power devices is connected to corresponding one of the at least one convergence device. Each of the plurality of groups of power devices includes a plurality of power devices connected to at least one of the plurality of DC power supplies, respectively. The method includes identifying at least one information identification diagram corresponding to each of the at least one convergence device to obtain electrical topology location information and device information of each of power devices connected to each of the at least one convergence device; and generating an electrical topology diagram of the power system based on the electrical topology location information and the device information of the power devices connected to each of the at least one convergence device. The information identification diagram includes at least one cell. Each of the at least one cell has a device identifier of corresponding one of the plurality of power devices and electrical topology location information of the one of the plurality of power devices.

In an embodiment, identifying the at least one information identification diagram corresponding to each of the at least one convergence device to obtain the electrical topology location information and the device information of each of the power devices connected to each of the at least one convergence device further includes: identifying a device identifier of each of power devices in each of the at least one information identification diagram to obtain the device information of the power devices; and identifying row and column location information of a corresponding one of the at least one cell where each device identifier is located, and obtaining electrical topology location information of each of the power devices based on a mapping rule. The mapping rule is configured to determine a one-to-one mapping relationship between the row and column location information of the at least one cell in the information identification diagram and the electrical topology location information of the power devices.

In an embodiment, generating the electrical topology diagram of the power system based on the electrical topology location information and the device information of the power devices connected to each of the at least one convergence device further includes: storing the device information and the electrical topology location information of each of the power devices in an information list in association with each other to obtain the electrical topology diagram.

In an embodiment, generating the electrical topology diagram of the power system based on the electrical topology location information and the device information of the power devices connected to each of the at least one convergence device further includes: generating an electrical topology block diagram of the power system based on the electrical topology location information of each of the power devices connected to each of the at least one convergence device; and binding the device information of each of the power devices connected to each of the at least one convergence device with a corresponding power device in the electrical topology block diagram to obtain the electrical topology diagram.

In an embodiment, in a case where there are a plurality of convergence devices, generating the electrical topology diagram of the power system based on the electrical topology location information and the device information of the power devices connected to each of the at least one convergence device further includes: generating corresponding electrical topology relationship sub-diagrams based on the electrical topology location information and the device information of the power devices connected to each of the plurality of convergence devices; and binding the corresponding electrical topology relationship sub-diagrams to obtain the electrical topology diagram of the power system.

In an embodiment, the method further includes: acquiring at least one real-time device parameter of the power devices connected to each of the at least one convergence devices; and binding the at least one device real-time parameter with either or both of electrical topology location information and device information of a corresponding power device in the electrical topology diagram.

In an embodiment, the method further includes: sending the electrical topology diagram to a management module corresponding to each of the at least one convergence device to implement networking of the power devices.

In an embodiment, the electrical topology location information at least includes a group number of a corresponding group of power devices to which a corresponding power device belongs and a ranking of the corresponding power device in the group of power devices to which the corresponding power device belongs.

In a second aspect, an apparatus for generating an electrical topology diagram of a power system is provided in an embodiment of the present invention. The power system includes a plurality of direct current (DC) power supplies, a plurality of groups of power devices, and at least one convergence device. Each of the plurality of groups of power devices is connected to corresponding one of the at least one convergence device. Each of the plurality of groups of power devices includes a plurality of power devices connected to at least one of the plurality of DC power supplies, respectively. The apparatus includes an identification module and a generation module. The identification module is configured for identifying at least one information identification diagram corresponding to each of the at least one convergence device to obtain electrical topology location information and device information of each of power devices connected to each of the at least one convergence device. The generation module is configured for generating an electrical topology diagram of the power system based on the electrical topology location information and the device information of the power devices connected to each of the at least one convergence device. The information identification diagram includes at least one cell, and each of the at least one cell has a device identifier of corresponding one of the plurality of power devices and electrical topology location information of the one of the plurality of power devices.

In a third aspect, a computer-readable storage medium having a computer program stored thereon is provided in an embodiment of the present invention. The computer program, when executed by a processor, implements steps of the method described in the first aspect.

Details of one or more embodiments of the present invention are presented in the attached drawings and descriptions below. And other features, purposes and advantages of the present invention will become apparent from the description, drawings, and claims.

### BRIEF DESCRIPTION OF THE DRAWINGS

To more clearly illustrate the technical solutions in the embodiments of the present invention or in the related art, the accompanying drawings used in the embodiments or the description of the related art will be briefly introduced below. Apparently, the drawings in the following description are only some embodiments of the present invention. For those skilled in the art, other drawings may also be derived from these drawings without creative efforts.
FIG. 1 is a schematic structural diagram of a power system according to an embodiment.
FIG. 2 is a schematic structural diagram of a power system according to another embodiment.
FIG. 3 is a schematic flowchart of a method for generating an electrical topology diagram according to an embodiment.
FIG. 4 is a schematic diagram of a template of an information identification diagram according to an embodiment.
FIG. 5 is a schematic flowchart of a method for identifying an information identification diagram according to an embodiment.
FIG. 6 is a schematic diagram of an information identification diagram according to a first exemplary embodiment.
FIG. 7 is a schematic structural diagram of a power system according to the first exemplary embodiment.
FIG. 8 is a schematic diagram of an information identification diagram according to a second exemplary embodiment.
FIG. 9 is a schematic structural diagram of a power system according to the second exemplary embodiment.
FIG. 10 is another schematic diagram of an information identification diagram according to the second exemplary embodiment.
FIG. 11 is a schematic diagram of an information identification diagram according to a third exemplary embodiment.
FIG. 12 is a schematic structural diagram of a power system according to the third exemplary embodiment.
FIG. 13A is a schematic diagram of an information identification diagram according to a fourth exemplary embodiment.
FIG. 13B is a schematic diagram of another information identification diagram according to the fourth exemplary embodiment.
FIG. 14 is a schematic structural diagram of a power system according to the fourth exemplary embodiment.
FIG. 15 is a schematic flowchart of a specific method for generating an electrical topology diagram according to an embodiment.
FIG. 16 is a schematic structural diagram of a power system according to an exemplary embodiment.
FIG. 17 is a schematic diagram of an electrical topology block diagram according to an exemplary embodiment.
FIG. 18 is a schematic diagram of an electrical topology diagram according to an exemplary embodiment.
FIG. 19 is a schematic diagram of an electrical topology diagram according to another exemplary embodiment.
FIG. 20 is a schematic flowchart of a specific method for generating an electrical topology diagram according to another embodiment.
FIG. 21 is a schematic diagram of an electrical topology diagram according to yet another exemplary embodiment.
FIG. 22 is a schematic structural diagram of an apparatus for generating an electrical topology diagram according to an embodiment.

### DETAILED DESCRIPTION

To more clearly illustrate the technical solutions in the embodiments of the present invention, the accompanying drawings used in the embodiments or the description of the related art will be briefly introduced below. The drawings in the following description are only some embodiments of the present invention. For those skilled in the art, the present invention may also be applied to other similar scenarios according to these drawings without creative efforts. Unless apparent from the context of language or otherwise described, like reference numerals represent like structures or operations.

As shown in the description and the claims, unless the context clearly indicates otherwise, words such as "a", "an", "one", and/or "the" are not intended to refer specifically to the singular, but may also include the plural. Generally speaking, the terms "comprise" and "include" only indicate the inclusion of clearly identified steps and elements, and these steps and elements do not constitute an exclusive list, and the method or device may also include other steps or elements.

Although the present invention makes various references to certain modules in a system according to embodiments of the present invention, any number of different modules may be used and run on a computing device and/or processor. The modules are merely illustrative, and different aspects of the system and method may use different modules.

It should be understood that when a unit or module is described as being "connected", "coupled", to other units, modules, or blocks, it may refer to direct connection or coupling, or in communication with other units, modules, or blocks, or there may be intervening units, modules, or blocks, unless the context clearly dictates otherwise. As used herein, the term "and/or" may include any and all combinations of one or more of the associated listed items.

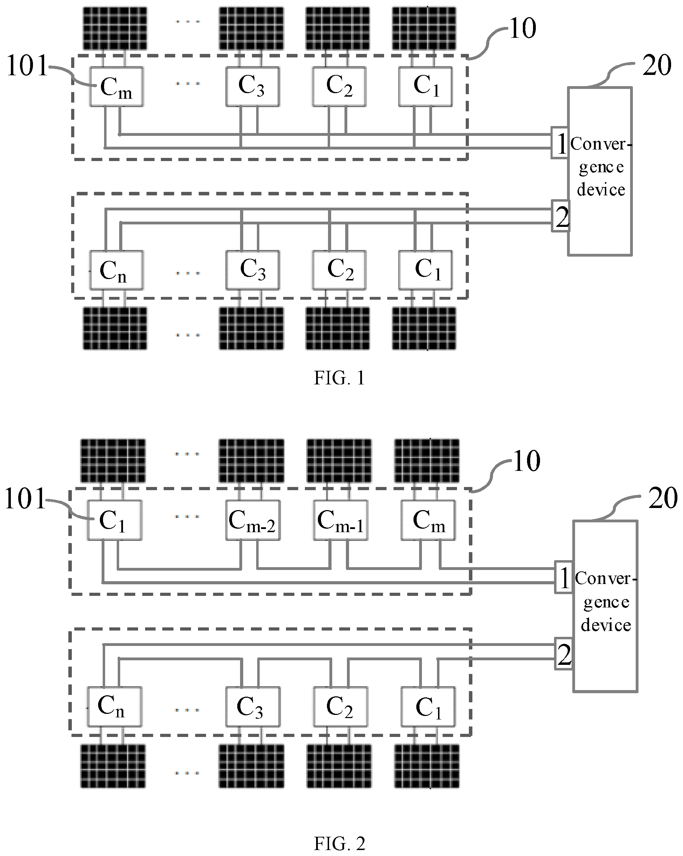

FIG. 1 and FIG. 2 are schematic structural diagrams of a power system according to the present invention. The power system includes a plurality of direct current (DC) power supplies, a plurality of groups of power devices (which may also be referred to as a plurality of power device groups) 10, and at least one convergence device 20. Each of the power device groups 10 is connected to corresponding one of the at least one convergence device 20, and each of the power device groups 10 includes a plurality of power devices 101 connected to at least one of the plurality of DC power supplies.

The DC power supply may be a photovoltaic DC power supply as shown in FIG. 1 and FIG. 2, or may be a fuel cell and an energy storage cell. Specifically, the photovoltaic DC power supply may be a single photovoltaic component, or may be a plurality of photovoltaic components connected in series and/or in parallel, or may be a plurality of photovoltaic cell sub-strings connected in series and/or in parallel.

The power device 101 may be a micro-inverter, a shutdown device, an optimizer, a monitor, or the like. A plurality of power devices 101 in a same power device group 10 may be connected in parallel as shown in FIG. 1, or may be connected in series as shown in FIG. 2.

Each power device has corresponding electrical topology location information. The electrical topology location information may at least include a group number of a power device group to which the power device belongs and a ranking of the power device in the power device group to which the power device belongs. Each power device group may have a group number, and the group number of the power device group may be represented by an input port number of a convergence device to which the power device group is connected, for example, 1, 2, 3, 4, etc. Each power device may have a relative position ranking in the power device group to which the power device belongs. For example, as shown in FIG. 1, the power devices in the power device group may sequentially be numbered as 1, 2, 3, ..., and m from a position closest to an input port of the convergence device to a position farthest from the input port of the convergence device. Alternatively, as shown in FIG. 2, the power devices in the power device group may sequentially be numbered as 1, 2, 3, ..., and n from a positive electrode to a negative electrode of the power device group. The electrical topology location information may also include a convergence device number. The electrical topology location information of the power device may usually be represented as X-Y-Z, where X may represent the convergence device number, Y may represent the input port number of the convergence device, and Z may represent the ranking of the power device in the power device group to which the power device belongs.

Each power device may have corresponding device information. The device information may be unique identification information such as a device serial number of the power device. A carrier of the device information, i.e., a device identifier, may be a two-dimensional code provided on the power device, and the two-dimensional code may be configured to indicate the device information of the power device. It may be understood that the device identifier may not be limited to the two-dimensional code, and may also be other forms of information carrier or identification symbols such as a one-dimensional code.

Herein, the convergence device 20 may be an inverter configured to invert direct current provided by the power device group into alternating current and output the alternating current. Alternatively, the convergence device 20 may be a direct current (DC) convergence box or an alternating current (AC) convergence box configured to converge direct current or alternating current output by each power device group. FIG. 1 and FIG. 2 illustrate an example in which one convergence device is connected to two power device groups. It may be understood that the power system may include two or more convergence devices 20, and each of the convergence devices 20 may have one or more input ports. Each power device group 10 may be connected to corresponding one input port of one convergence device 20.

The power system may further include at least one management module. Each of the at least one management module may correspond to one convergence device 20, and the management module may be configured to communicate with each power device group connected to the convergence device. For example, the management module may be coupled to each power device group connected to the convergence device via a current transformer, and configured to communicate with each power device, for example, via power line carrier communication, but not be limited thereto. The management module may also be integrated into the corresponding convergence device 20. The management module and the convergence device may have a unique identifier, respectively, or their unique identifiers may be unified into one. Generally, a management module identifier or the unified identifier may be used to represent the convergence device. The management module may be implemented by a controller or the like.

The power system may also include a gateway device and a monitoring platform. The gateway device may be compatible with multiple different data transmission modes simultaneously, and can be configured to communicate with the management module and each power device and perform data transmission with the monitoring platform and/or an APP (Application). The monitoring platform can be configured to perform data interaction with the gateway device and/or the APP, enabling online monitoring, fault diagnosis, intelligent alarm, and operation and maintenance management of the power system on the platform, automatically monitoring operating status of each mounted power device, and automatically alarming when abnormal operation occurs.

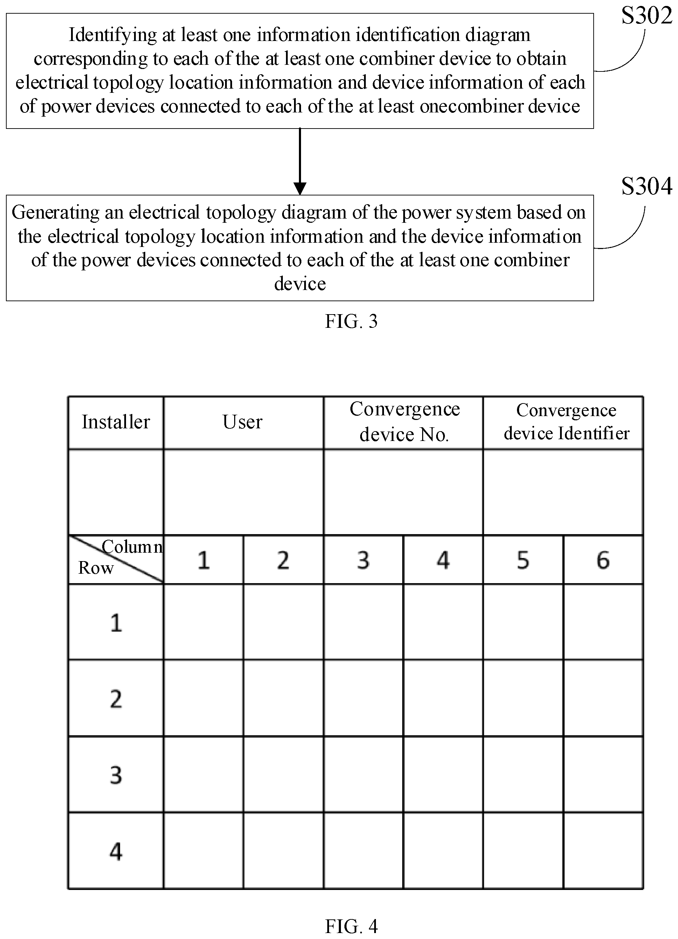

A method for generating an electrical topology diagram of a power system is provided in the present invention. As shown in FIG. 1 and FIG. 2, the power system may include a plurality of DC power supplies, a plurality of power device groups 10, and at least one convergence device 20. Each of the plurality of power device groups 10 is connected to corresponding one of the at least one convergence device 20, and each of the plurality of power device groups 10 includes a plurality of power devices 101 connected to at least one of the DC power supplies. As shown in FIG. 3, the method includes step 302 and step 304.

Step 302 includes identifying at least one information identification diagram corresponding to each of the at least one convergence device to obtain electrical topology location information and device information of each of power devices connected to each of the at least one convergence device.

The information identification diagram includes at least one cell, and each of the at least one cell has a device identifier of corresponding one of the plurality of power devices and electrical topology location information of the one of the plurality of power devices.

The electrical topology location information of a power device may at least include a group number of a power device group to which the power device belongs and a ranking of the power device in the power device group to which the power device belongs. Furthermore, the electrical topology location information may further include the number of the convergence device.

The device information may be, for example, a device serial number of the power device.

Step 304 includes generating an electrical topology diagram of the power system based on the electrical topology location information and the device information of the power devices connected to each of the at least one convergence device.

It may be understood that in the present invention, the electrical topology diagram of the power system may be configured to display the electrical topology location information and device information of each power device and a correlation therebetween. The electrical topology diagram may be in a form of an information list, a topology diagram, or other forms of diagrams convenient to display.

Based on the step 302 to step 304, the power system may be divided by taking the convergence device as a unit. By identifying the information identification diagram, the electrical topology location information and the device information of the power devices connected to each convergence device are obtained, providing a more easily implementable method for generating the electrical topology diagram of the power system, facilitating the realization of intelligent operation and maintenance of the power system, and improving the efficiency of operation and maintenance of the power system.

A template of the information identification diagram shown in FIG. 4 may include a table region. Each cell in the table may be configured to paste a device identifier of a power device, and row and column location information of the cell and electrical topology location information of the power device may have a one-to-one mapping relationship.

According to the mapping relationship, the device identifiers of all power devices corresponding to one convergence device may sequentially be pasted into cells in the template of the information identification diagram to obtain the information identification diagram.

Alternatively, the template of the information identification diagram may further include a number cell and an identification cell of a convergence device, which are configured to fill in the number of the convergence device and the unique identifier of the convergence device, respectively.

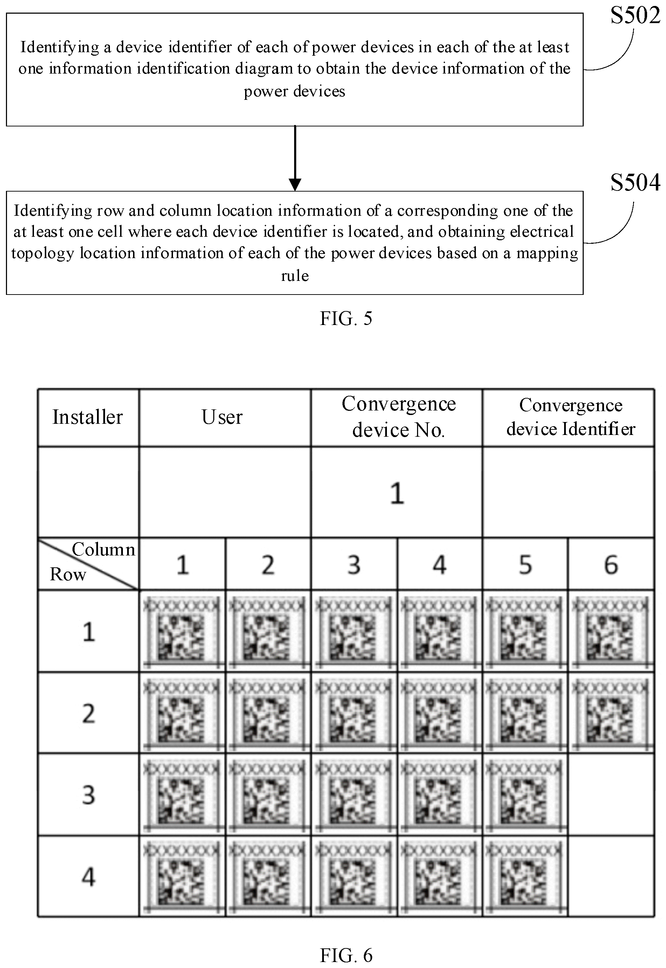

In an embodiment, as shown in FIG. 5, identifying the at least one information identification diagram corresponding to each of the at least one convergence device to obtain the electrical topology location information and the device information of each of the power devices connected to each of the at least one convergence device may further include step 502 and step 504.

Step 502 may include identifying a device identifier of each of power devices in each of the at least one information identification diagram to obtain the device information of the power devices.

Step 504 may include identifying row and column location information of a corresponding one of the at least one cell where each device identifier is located, and obtaining electrical topology location information of each of the power devices based on a mapping rule.

The mapping rule may be configured to determine a one-to-one mapping relationship between the row and column location information of the at least one cell in the information identification diagram and the electrical topology location information of the power device.

The mapping rule may be automatically obtained based on an actual electrical topology design scheme corresponding to the convergence device and a table design of the template of the information identification diagram, or may be manually input.

For example, a target picture may be obtained by taking a photo of the information identification diagram using a camera function of an electronic device, or by scanning the information identification diagram using a scanning function of an electronic device. Then, the electronic device may be configured to identify the target picture, including identify a device identifier of a power device in each cell to obtain device information, and identify the row and column location information of the cell where each device identifier is located, and obtain the electrical topology location information of each power device based on the mapping rule, thereby obtaining the device information and electrical topology location information of the power device corresponding to each cell.

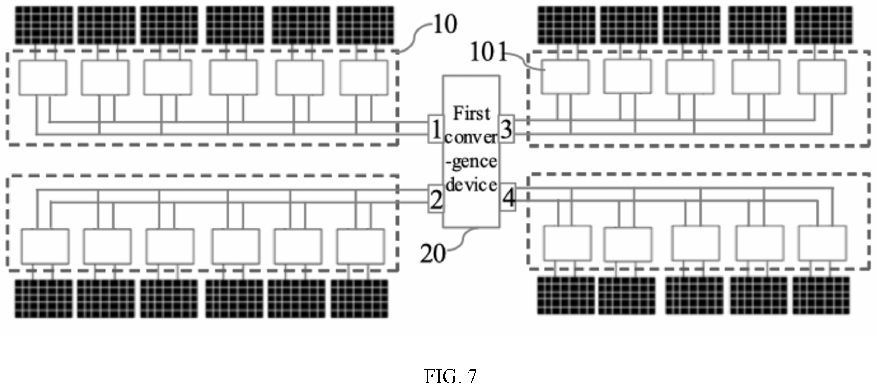

In a first exemplary embodiment, an information identification diagram shown in FIG. 6 may be provided for recording device identifiers of power devices connected to a first convergence device shown in FIG. 7. An entire table in the information identification diagram may represent all power devices connected to one convergence device, and each cell of the table may represent one power device. Each cell in the information identification diagram may have a corresponding device identifier. It may be understood that a blank cell may indicate no power device is connected at the corresponding position.

The identification information of the convergence device corresponding to the information identification diagram may include a serial number and/or a device identifier of the convergence device. The serial number of the convergence device may be filled in a convergence device number cell in the information identification diagram, and the device identifier of the convergence device may be filled in a convergence device identifier cell in the information identification diagram.

The information identification diagram may be identified by an electronic device to obtain the device information of the power device corresponding to each cell. Then, the electrical topology location information and the device information of the power device may be stored in the information list shown in Table 1 in association with each other.

Each cell in the information identification diagram may be identified by the electronic device based on a mapping rule. The mapping rule may be configured to determine a one-to-one mapping relationship between row and column locations of a cell in the information identification diagram and an electrical topology location of the power device. In this exemplary embodiment, the mapping rule may include that: each row of cells represents one power device group, a column number of a cell represents a ranking number of a corresponding power device in the power device group. A group number of the power device group may be a row number.

It may be understood that in other embodiments, each column of the information identification diagram may represent a power device group, and a row number of a cell may indicate a ranking number of a corresponding power device in the power device group.

When the number of power devices in the at least one power device group is too large, i.e., the number of cells in one row in the information identifier diagram is less than the number of power devices in a certain power device group, device identifiers of all power devices in the power device group may be filled in cells in a plurality of rows.

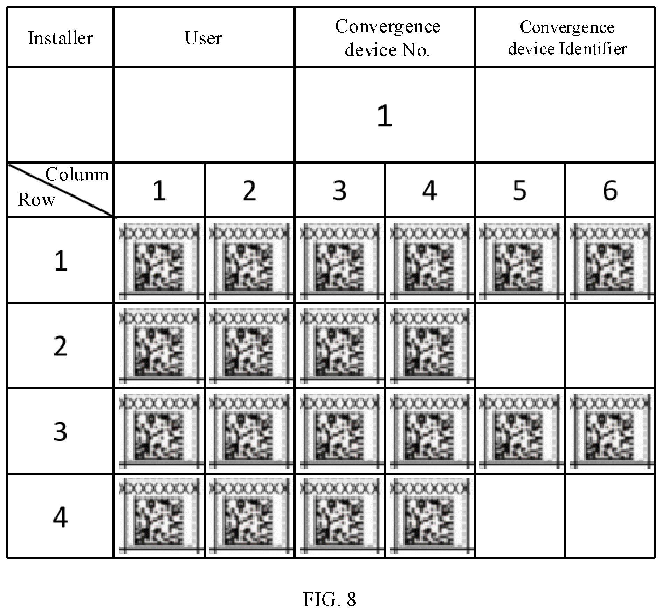

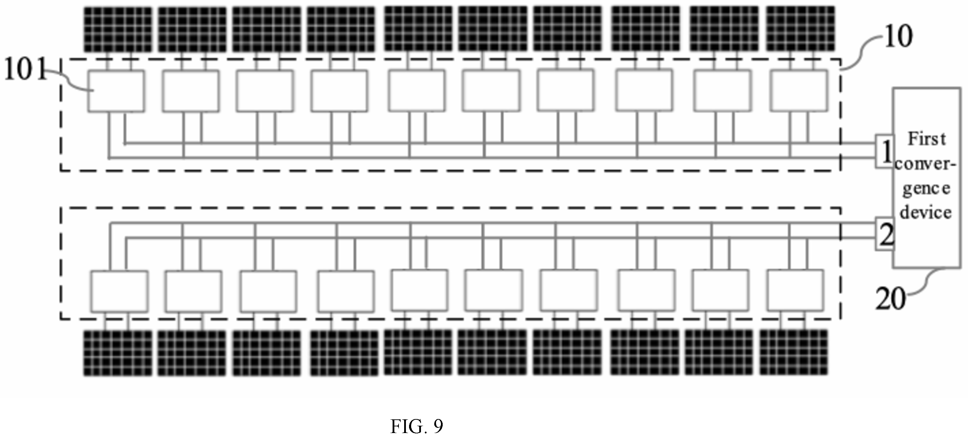

In a second exemplary embodiment, an information identification diagram shown in FIG. 8 may be provided for recording device identifiers of power devices connected to the first convergence device shown in FIG. 9. As shown in FIG. 8, both a first row and a second row of the information identifier diagram may be configured to be filled with device identifiers of power devices in the first power device group, and both a third row and a fourth row of the information identifier diagram may be configured to be filled with device identifiers of power devices in the second power device group.

Therefore, each cell in the information identification diagram shown in FIG. 8 may be identified by the electronic device based on the mapping rule to obtain the device information of the power device in each cell. Then, the electrical topology location information and the device information of the power device may be stored in the information list shown in Table 2 in association with each other. In this exemplary embodiment, the mapping rule may include that two rows of cells represent one power device group, and group numbers of power device groups are sequentially ordered according to relative positions of the power device groups in the table.

**Table 1**

| Electrical Topology Location Information | Device Information |
|---|---|
| 1-1-1 | xxxxxx01 |
| 1-1-2 | xxxxxx02 |
| 1-1-3 | xxxxxx03 |
| 1-1-4 | xxxxxx04 |
| 1-1-5 | xxxxxx05 |
| 1-1-6 | xxxxxx06 |
| 1-2-1 | xxxxxx07 |
| 1-2-2 | xxxxxx08 |
| 1-2-3 | xxxxxx09 |
| 1-2-4 | xxxxxx10 |
| 1-2-5 | xxxxxx11 |
| 1-2-6 | xxxxxx12 |
| 1-3-1 | xxxxxx13 |
| 1-3-2 | xxxxxx14 |
| 1-3-3 | xxxxxx15 |
| 1-3-4 | xxxxxx16 |
| 1-3-5 | xxxxxx17 |
| 1-4-1 | xxxxxx18 |
| 1-4-2 | xxxxxx19 |
| 1-4-3 | xxxxxx20 |
| 1-4-4 | xxxxxx21 |
| 1-4-5 | xxxxxx22 |

**Table 2**

| Electrical Topology Location Information | Device Information |
|---|---|
| 1-1-1 | xxxxxx01 |
| 1-1-2 | xxxxxx02 |
| 1-1-3 | xxxxxx03 |
| 1-1-4 | xxxxxx04 |
| 1-1-5 | xxxxxx05 |
| 1-1-6 | xxxxxx06 |
| 1-1-7 | xxxxxx07 |
| 1-1-8 | xxxxxx08 |
| 1-1-9 | xxxxxx09 |
| 1-1-10 | xxxxxx10 |
| 1-2-1 | xxxxxx11 |
| 1-2-2 | xxxxxx12 |
| 1-2-3 | xxxxxx13 |
| 1-2-4 | xxxxxx14 |
| 1-2-5 | xxxxxx15 |
| 1-2-6 | xxxxxx16 |
| 1-2-7 | xxxxxx17 |
| 1-2-8 | xxxxxx18 |
| 1-2-9 | xxxxxx19 |
| 1-2-10 | xxxxxx20 |

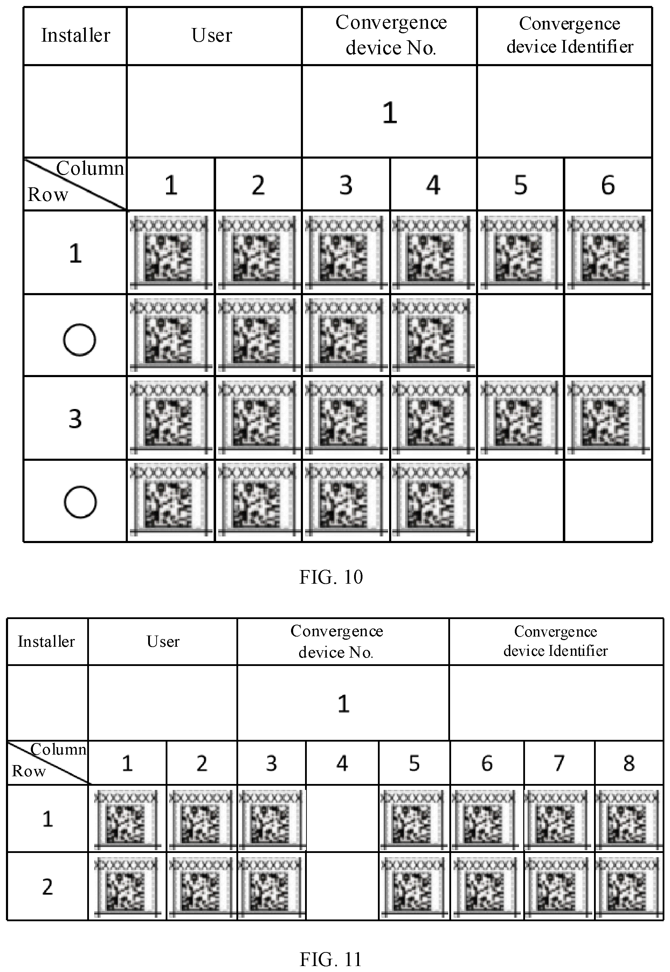

In other examples, the table design of the template of the information identification diagram may also be changed. For example, if a row of the table does not have a group number of a power device group, the row may be a continuation of a previous row having a group number of a power device group. For example, the second row in the information identification diagram may not have a group number of a power device group, and the second row may be a continuation of the previous row having a group number of a power device group, i.e., a continuation of the first row. Alternatively, as shown in FIG. 10, a special mark may be designed at positions corresponding to group numbers of some rows of the table to indicate that the row is a continuation of a previous row having a group number of the power device group. For example, a position corresponding to a group number of the second row in the information identification diagram may have a special mark, and thus the second row may be a continuation of the previous row with the group number of the power device group, i.e., the continuation of the first row. Therefore, the electrical topology location information corresponding to the cell (2, 1) may be 1-7, and configured to indicate a location of a seventh power device in the first power device group.

Also, there may be a situation where there are few power devices in one power device group, i.e., when the number of cells in one row in the information identifier diagram is much larger than that of power devices in a certain power device group, the device identifiers of the power devices in a plurality of power device groups may be filled in cells in one row.

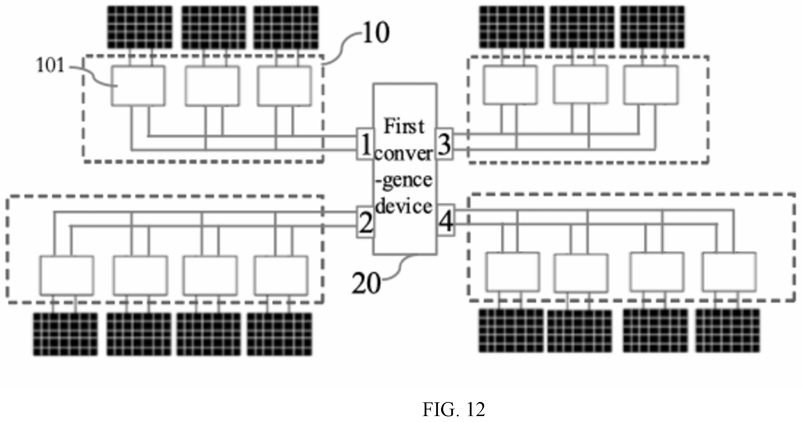

In a third exemplary embodiment, an information identification diagram shown in FIG. 11 may be provided for recording device identifiers of power devices connected to the first convergence device shown in FIG. 12. As shown in FIG. 11, a first row of the information identifier diagram may be configured to be filled with device identifiers of power devices in the first power device group and the second power device group, and a second row may be configured to be filled with device identifiers of power devices in the third power device group and the fourth power device group.

Therefore, each cell in the information identification diagram shown in FIG. 11 may be identified by the electronic device based on the mapping rule to obtain the device information of the power device in each cell. Then, the electrical topology location information and the device information of the power device may be stored in the information list shown in Table 3 in association with each other. In this exemplary embodiment, the mapping rule may include that one row represents two power device groups, and the group numbers of the power device groups are sequentially ordered according to the relative positions of the power device groups in the table.

**Table 3**

| Electrical Topology Location Information | Device Information |
|---|---|
| 1-1-1 | xxxxxx01 |
| 1-1-2 | xxxxxx02 |
| 1-1-3 | xxxxxx03 |
| 1-2-1 | xxxxxx04 |
| 1-2-2 | xxxxxx05 |
| 1-2-3 | xxxxxx06 |
| 1-2-4 | xxxxxx07 |
| 1-3-1 | xxxxxx08 |
| 1-3-2 | xxxxxx09 |
| 1-3-3 | xxxxxx10 |
| 1-4-1 | xxxxxx11 |
| 1-4-2 | xxxxxx12 |
| 1-4-3 | xxxxxx13 |
| 1-4-4 | xxxxxx14 |

When the number of power devices connected to one convergence device is too large, device identifiers of power devices connected to one convergence device may also be recorded by a plurality of information identifier diagrams. The identification information of the convergence device, such as a serial number and an identifier of the convergence device, may be marked at specified positions of the plurality of information identification diagrams. Alternatively, the serial number of the convergence device may be recorded at a convergence device number cell in each information identification diagram, while the convergence device identifier may be only filled in a convergence device identifier cell in the first information identification diagram. The information identification diagram may further have a page number identification area configured to indicate a splicing order of the plurality of information identification diagrams.

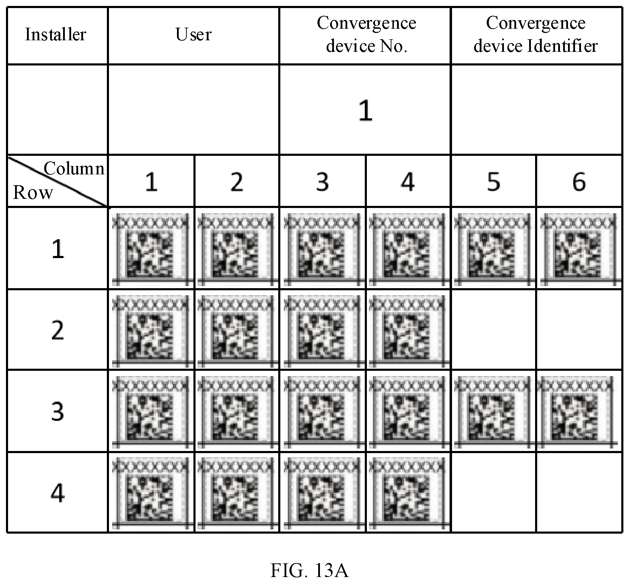

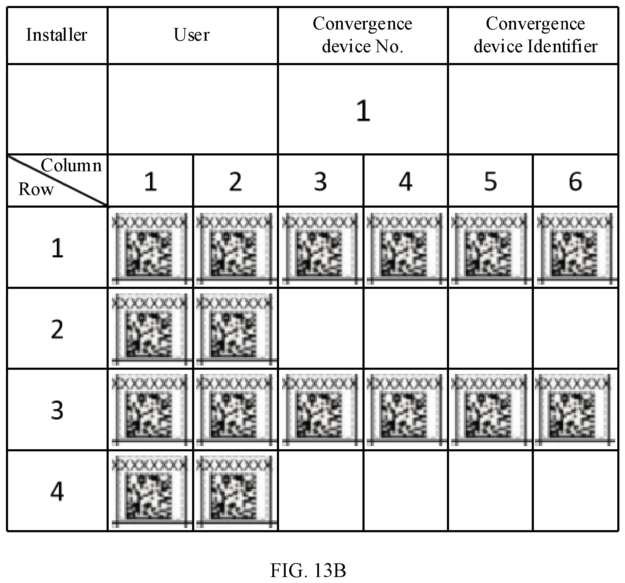

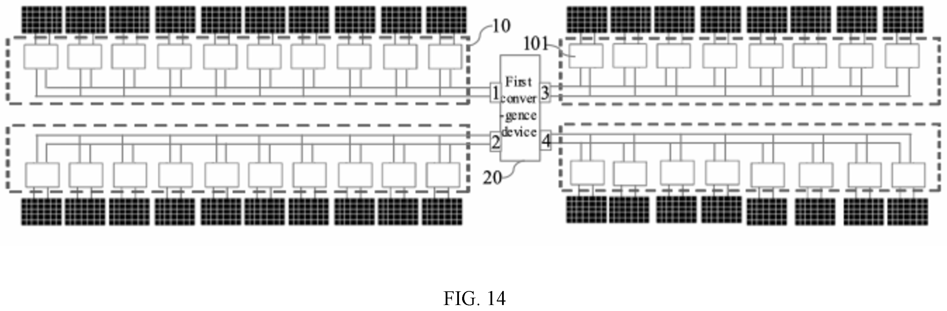

In a fourth exemplary embodiment, the two information identification diagrams shown in FIG. 13A and FIG. 13B may be filled with device identifiers of power devices connected to the first convergence device shown in FIG. 14. It may be understood that device identifiers of all power devices in a same power device group may be filled in a same table as much as possible.

Therefore, each cell in the information identification diagram shown in FIG. 13A and FIG. 13B may be identified by the electronic device based on the mapping rule to obtain the device information of the power device in each cell. Then, the obtained information may be integrated, such that the electrical topology location information and the device information of all power devices connected to the first convergence device may be stored in the information list shown in Table 4 in associate with each other.

**Table 4**

| Electrical Topology Location Information | Device Information |
|---|---|
| 1-1-1 | xxxxxx01 |
| 1-1-2 | xxxxxx02 |
| 1-1-3 | xxxxxx03 |
| 1-1-4 | xxxxxx04 |
| 1-1-5 | xxxxxx05 |
| 1-1-6 | xxxxxx06 |
| 1-1-7 | xxxxxx07 |
| 1-1-8 | xxxxxx08 |
| 1-1-9 | xxxxxx09 |
| 1-1-10 | xxxxxx10 |
| 1-2-1 | xxxxxx11 |
| 1-2-2 | xxxxxx12 |
| 1-2-3 | xxxxxx13 |
| 1-2-4 | xxxxxx14 |
| 1-2-5 | xxxxxx15 |
| 1-2-6 | xxxxxx16 |
| 1-2-7 | xxxxxx17 |
| 1-2-8 | xxxxxx18 |
| 1-2-9 | xxxxxx19 |
| 1-2-10 | xxxxxx20 |
| 1-3-1 | xxxxxx21 |
| 1-3-2 | xxxxxx22 |
| 1-3-3 | xxxxxx23 |
| 1-3-4 | xxxxxx24 |
| 1-3-5 | xxxxxx25 |
| 1-3-6 | xxxxxx26 |
| 1-3-7 | xxxxxx27 |
| 1-3-8 | xxxxxx28 |
| 1-4-1 | xxxxxx29 |

At step 304, based on the information list corresponding to each convergence device, the electrical topology position information and corresponding device information of power devices connected to each convergence device may be summarized and integrated, thereby generating an electrical topology diagram of the power system.

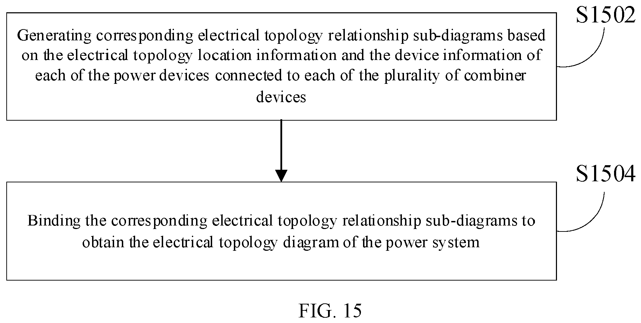

Furthermore, as shown in FIG. 15, in a case where there are a plurality of convergence devices, generating the electrical topology diagram of the power system based on the electrical topology location information and the device information of the power devices connected to each of the at least one convergence device may further include step 1502 and step 1504.

Step 1502 may include generating corresponding electrical topology relationship sub-diagrams based on the electrical topology location information and the device information of each of the power devices connected to each of the plurality of convergence devices.

Step 1504 may include binding the corresponding electrical topology relationship sub-diagrams to obtain the electrical topology diagram of the power system.

The electrical topology diagram may have various forms. In some embodiments, generating the electrical topology diagram of the power system based on the electrical topology location information and the device information of the power devices connected to each of the at least one convergence device may further include: storing the device information and the electrical topology location information of each of the power devices in an information list in association with each other to obtain the electrical topology diagram.

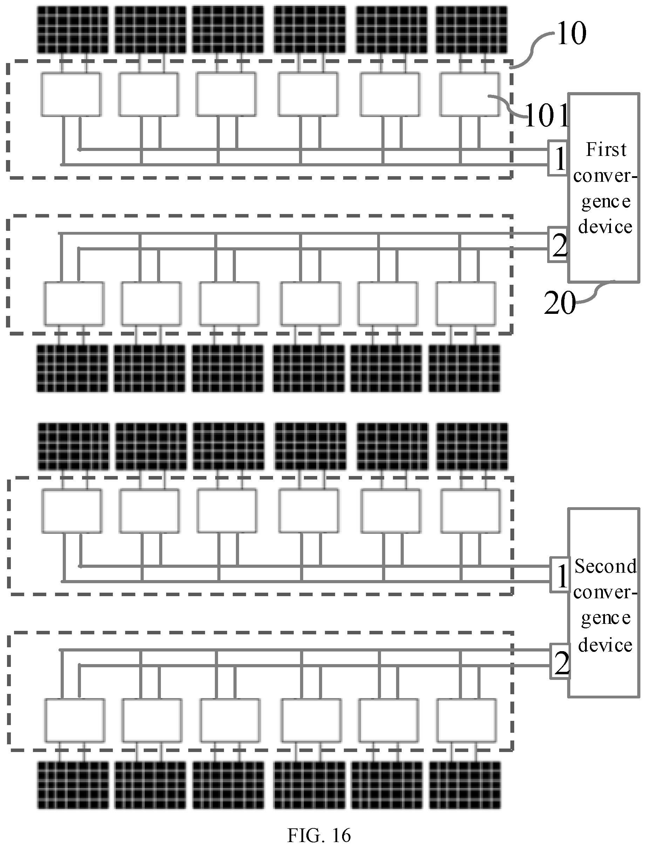

The electrical topology diagram may directly store the electrical topology location information and the device information of each power device in the power system in the same row in a form of an information list shown in Table 5. The electrical topology location information of the power device may further include a serial number of the connected convergence device. For example, as shown in FIG. 16, the power system may include a first convergence device and a second convergence device connected to two power device groups, respectively, and each of the two power device groups may include six power devices.

In some other embodiments, generating the electrical topology diagram of the power system based on the electrical topology location information and the device information of the power devices connected to each of the at least one convergence device may further include: generating an electrical topology block diagram of the power system based on the electrical topology location information of each of the power devices connected to each of the at least one convergence device; and binding the device information of each of the power devices connected to each of the at least one convergence device with a corresponding power device in the electrical topology block diagram to obtain the electrical topology diagram.

**Table 5**

| Electrical Topology Location Information | Device Information |
|---|---|
| 1-1-1 | xxxxxx01 |
| 1-1-2 | xxxxxx02 |
| 1-1-3 | xxxxxx03 |
| 1-1-4 | xxxxxx04 |
| 1-1-5 | xxxxxx05 |
| 1-1-6 | xxxxxx06 |
| 1-2-1 | xxxxxx07 |
| 1-2-2 | xxxxxx08 |
| 1-2-3 | xxxxxx09 |
| 1-2-4 | xxxxxx10 |
| 1-2-5 | xxxxxx11 |
| 1-2-6 | xxxxxx12 |
| 2-1-1 | xxxxxx13 |
| 2-1-2 | xxxxxx14 |
| 2-1-3 | xxxxxx15 |
| 2-1-4 | xxxxxx16 |
| 2-1-5 | xxxxxx17 |
| 2-1-6 | xxxxxx18 |
| 2-2-1 | xxxxxx19 |
| 2-2-2 | xxxxxx20 |
| 2-2-3 | xxxxxx21 |
| 2-2-4 | xxxxxx22 |
| 2-2-5 | xxxxxx23 |
| 2-2-6 | xxxxxx24 |

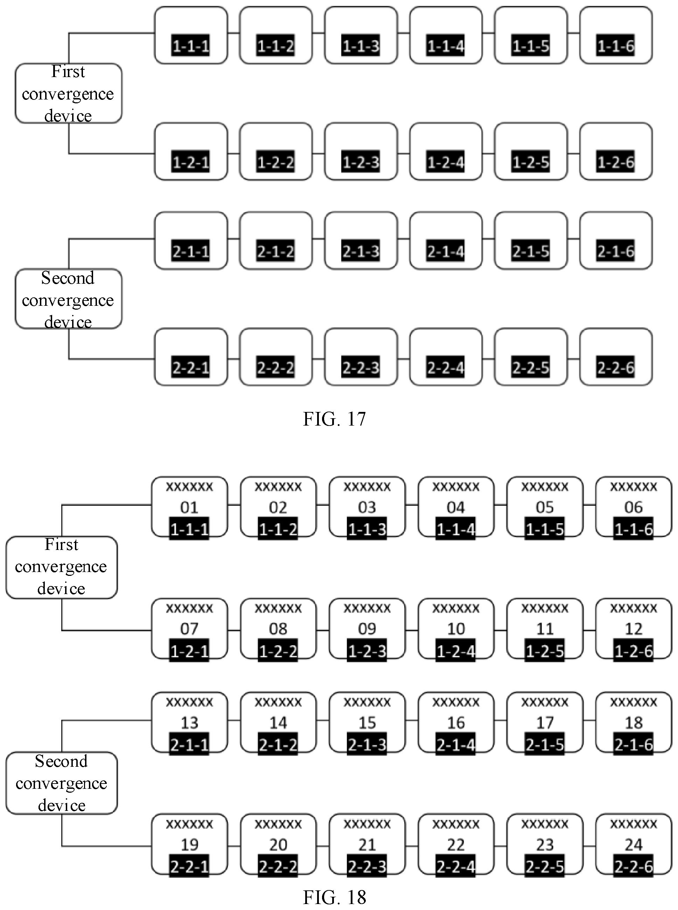

Specifically, an electrical topology block diagram of the power system may be generated based on the electrical topology location information of each of power devices corresponding to each convergence device. As shown in FIG. 17, the electrical topology block diagram may be a block diagram including convergence devices and power devices and electrical connection relationships thereof. 1-1-1 in FIG. 17 may represent electrical topology location information of a corresponding power device. Then, the device information of each power device may be bound with a corresponding power device in the electrical topology diagram to obtain the electrical topology diagram.

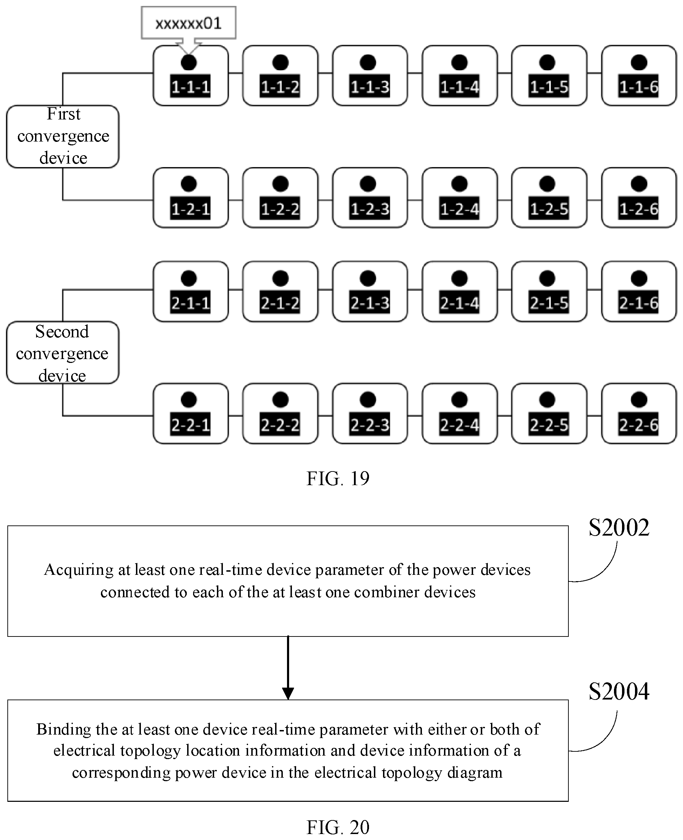

Herein, binding the device information of each power device with the corresponding power device in the electrical topology diagram may be specifically implemented in any one of the following ways: directly displaying any device information on the corresponding at least one power device as shown in FIG. 18; displaying any device information on an icon, and displaying the icon on the corresponding at least one power device; and storing any device information in association with icon information of an icon as shown in FIG. 19, and displaying the icon indicated by the icon information on the corresponding at least one power device, and the icon information may be any information configured to uniquely indicate an icon.

Furthermore, the electrical topology diagram of the power system may further include at least one real-time device parameter of each power device. Herein, the real-time device parameter may include at least one of a power generation amount, an output power, an output voltage, an output current, an input power, an input voltage, an input current, a device model, or a device operating state.

In an embodiment, as shown in FIG. 20, the method may further include step 2002 and step 2004.

Step 2002 may include acquiring at least one real-time device parameter of the power devices connected to each of the at least one convergence devices.

Step 2004 may include binding the at least one device real-time parameter with either or both of electrical topology location information and device information of a corresponding power device in the electrical topology diagram.

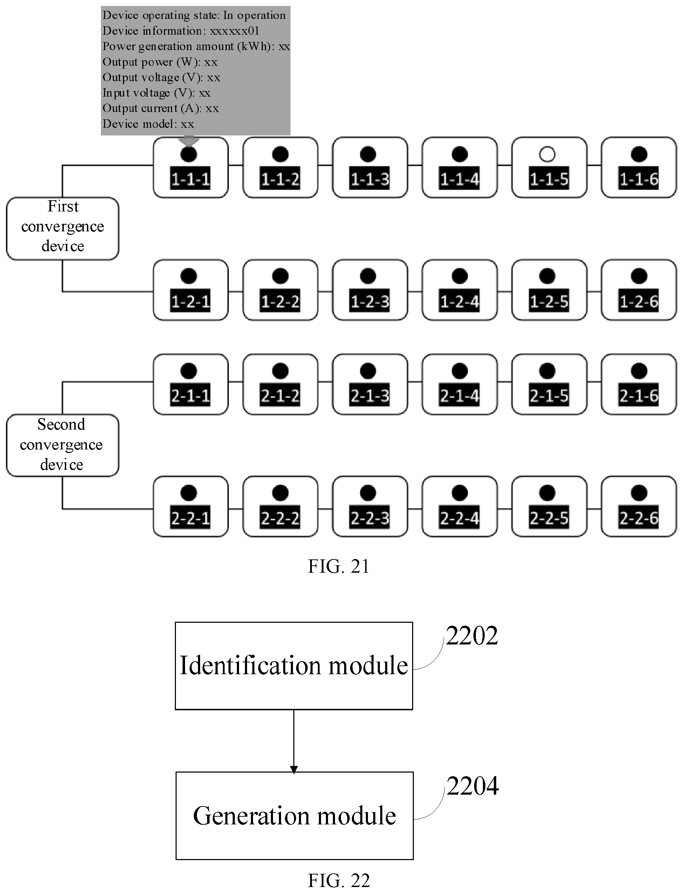

In the process of generating the electrical topology diagram of the power system, in addition to binding the electrical topology location information and the device information of the power device, the at least one real-time device parameter of the power device may also be bound with the electrical topology location information and the device information of the power device. Thus, in the electrical topology diagram as shown in Table 6 or FIG. 21, an abnormal/faulty power device can be directly located according to whether the real-time device parameter is abnormal. For example, the power device with the electrical topology location information of 1-1-5 and the device information of xxxxxx05 is abnormal. Therefore, intelligent operation and maintenance can be achieved and the efficiency of operation and maintenance can be improved.

In a further embodiment, in the process of generating the electrical topology diagram of the power system, identification information of each of the convergence devices may also be acquired, and the electrical topology diagram of the power system may be generated based on the electrical topology location information and the device information of the power device, and the identification information of the convergence devices. A device identifier of each convergence device may be identified by the electronic device to obtain identification information. Then, in the electrical topology diagram in the form of an information list, the identification information of the convergence device corresponding to each power device may also be stored in the same row together with the electrical topology location information and the device information of corresponding power device. Alternatively, the identification information of each convergence device may be bound with the corresponding convergence device in the electrical topology diagram. That is, the generated electrical topology diagram of the power system may further include the identification information of each convergence device.

Furthermore, after the electrical topology diagram of the power system is generated, the electrical topology diagram of each convergence device may be sent to the management module of corresponding convergence device. The electrical topology diagram may be directly distributed to a corresponding management module, or may be first synchronized to a gateway and then distributed by the gateway to the corresponding management module.

Based on the electrical topology diagram, device information of power devices connected to each convergence device may be obtained by a management module corresponding to the convergence device. Then, a signal instruction including the device information and a logical address may be sent by the management module to corresponding power device to implement networking. Therefore, each management module does not need to perform device search one by one to obtain the device information of the power devices, but can simply and quickly obtain, from the electrical topology diagram, the device information of all power devices connected to the corresponding convergence device, thereby improving networking efficiency.

**Table 6**

| Device Operating State | Electrical Topology Location Information | Device Information | Power Generation | Output Power (W) | Output Voltage (V) | Input Voltage (V) | Input Current (A) | Device Model |
|---|---|---|---|---|---|---|---|---|
| Operation | 1-1-1 | xxxxxx01 | XX | XX | XX | XX | XX | XX |
| Operation | 1-1-2 | xxxxxx02 | XX | XX | XX | XX | XX | XX |
| Operation | 1-1-3 | xxxxxx03 | XX | XX | XX | XX | XX | XX |
| Operation | 1-1-4 | xxxxxx04 | XX | XX | XX | XX | XX | XX |
| - | 1-1-5 | xxxxxx05 | - | - | - | - | - | - |
| Operation | 1-1-6 | xxxxxx06 | XX | XX | XX | XX | XX | XX |
| Operation | 1-2-1 | xxxxxx07 | XX | XX | XX | XX | XX | XX |
| Operation | 1-2-2 | xxxxxx08 | XX | XX | XX | XX | XX | XX |
| Operation | 1-2-3 | xxxxxx09 | XX | XX | XX | XX | XX | XX |
| Operation | 1-2-4 | xxxxxx10 | XX | XX | XX | XX | XX | XX |
| Operation | 1-2-5 | xxxxxx11 | XX | XX | XX | XX | XX | XX |
| Operation | 1-2-6 | xxxxxx12 | XX | XX | XX | XX | XX | XX |
| Operation | 2-1-1 | xxxxxx13 | XX | XX | XX | XX | XX | XX |
| Operation | 2-1-2 | xxxxxx14 | XX | XX | XX | XX | XX | XX |
| Operation | 2-1-3 | xxxxxx15 | XX | XX | XX | XX | XX | XX |
| Operation | 2-1-4 | xxxxxx16 | XX | XX | XX | XX | XX | XX |
| Operation | 2-1-5 | xxxxxx17 | XX | XX | XX | XX | XX | XX |
| Operation | 2-1-6 | xxxxxx18 | XX | XX | XX | XX | XX | XX |
| Operation | 2-2-1 | xxxxxx19 | XX | XX | XX | XX | XX | XX |
| Operation | 2-2-2 | xxxxxx20 | XX | XX | XX | XX | XX | XX |
| Operation | 2-2-3 | xxxxxx21 | XX | XX | XX | XX | XX | XX |
| Operation | 2-2-4 | xxxxxx22 | XX | XX | XX | XX | XX | XX |
| Operation | 2-2-5 | xxxxxx23 | XX | XX | XX | XX | XX | XX |
| Operation | 2-2-6 | xxxxxx24 | XX | XX | XX | XX | XX | XX |

It should be understood that although various steps in the flowchart are displayed in sequence as indicated by the arrows, these steps are not necessarily performed in sequence in the order indicated by the arrows. Unless expressly stated herein, the execution of these steps is not strictly limited in sequence, and these steps may be performed in other orders. Moreover, at least a part of the steps in the flowcharts related to the embodiments described above may include a plurality of steps or a plurality of stages, which are not necessarily performed at the same time, but may be executed at different times. The execution order of these sub-steps or stages is also not necessarily sequential, but may be performed alternately or interleaved with other steps or at least a part of the steps or stages of other steps.

In an embodiment, as shown in FIG. 22, an apparatus for generating an electrical topology diagram of a power system may be provided in the present invention. The power system includes a plurality of direct current (DC) power supplies, a plurality of groups of power devices, and at least one convergence device. Each of the plurality of groups of power devices is connected to corresponding one of the at least one convergence device. Each of the plurality of groups of power devices includes a plurality of power devices connected to at least one of the plurality of DC power supplies, respectively. The apparatus includes an identification module 2202 and a generation module 2204.

The identification module 2202 is configured to identify at least one information identification diagram corresponding to each of the at least one convergence device to obtain electrical topology location information and device information of each of power devices connected to each of the at least one convergence device. The information identification diagram includes at least one cell, and each of the at least one cell has a device identifier of corresponding one of the plurality of power devices and electrical topology location information of the one of the plurality of power devices.

The generation module 2204 is configured to generate an electrical topology diagram of the power system based on the electrical topology location information and the device information of the power devices connected to each of the at least one convergence device.

At least one information identification diagram corresponding to each convergence device is identified by the identification module to obtain electrical topology location information and device information of power devices connected to each convergence device. The electrical topology diagram of the power system is generated by the generation module based on the electrical topology location information and the device information of the power devices connected to each convergence device. According to the technical solution, a more easily implementable method for generating an electrical topology diagram of the power system is provided, facilitating the realization of intelligent operation and maintenance of the power system, and improving the efficiency of operation and maintenance of the power system.

In an embodiment, the identification module may include a first identification sub-module and a second identification sub-module.

The first identification sub-module may be configured to identify a device identifier of each of power devices in each of the at least one information identification diagram to obtain the device information of the power devices.

The second identification sub-module may be configured to identify row and column location information of a corresponding one of the at least one cell where each device identifier is located, and obtaining electrical topology location information of each of the power devices based on a mapping rule. The mapping rule may be configured to determine a one-to-one mapping relationship between the row and column location information of the at least one cell in the information identification diagram and the electrical topology location information of the power devices.

In an embodiment, the generation module may further be configured to store the device information and the electrical topology location information of the power devices in an information list in association with each other to obtain the electrical topology diagram.

In an embodiment, the generation module may further be configured to generate an electrical topology block diagram of the power system based on the electrical topology location information of each of the power devices connected to each of the at least one convergence device; and bind the device information of each of the power devices connected to each of the at least one convergence device with a corresponding power device in the electrical topology block diagram to obtain the electrical topology diagram.

In an embodiment, when there are a plurality of convergence devices, the generation module may further be configured to generate corresponding electrical topology relationship sub-diagrams based on the electrical topology location information and the device information of the power devices connected to each of the plurality of convergence devices; and bind the corresponding electrical topology relationship sub-diagrams to obtain the electrical topology diagram of the power system.

In an embodiment, the apparatus may further include a binding module.

The binding module may be configured to acquire at least one real-time device parameter of the power devices connected to each of the at least one convergence devices; and bind the at least one device real-time parameter with either or both of electrical topology location information and device information of a corresponding power device in the electrical topology diagram.

In an embodiment, the apparatus may further include a sending module.

The sending module may be configured to send the electrical topology diagram to a management module corresponding to each of the at least one convergence device to implement networking of the power devices.

In an embodiment, the electrical topology location information at least includes a group number of a corresponding group of power devices to which a corresponding power device belongs and a ranking of the corresponding power device in the group of power devices to which the corresponding power device belongs.

It should be noted that the apparatus for generating the electrical topology diagram of the power system may be an APP or a monitoring platform. The electrical topology diagram may be stored in the APP, the monitoring platform, the gateway device, and the management module of each convergence device of the power system, and the electrical topology diagram may support mutual synchronization and backup among the APP, the monitoring platform, the gateway device, and the management module. After generating the electrical topology diagram of the power system, the electrical topology diagram of each convergence device may be distributed to the management module of the convergence device by the APP based on a serial number of the convergence device, thereby implementing networking. Alternatively, after generating the electrical topology diagram of the power system, all electrical topology diagrams of the power system may be synchronized to the gateway device by the APP or the monitoring platform, and then the electrical topology diagram and some configuration parameters of each convergence device may be distributed to the management module of corresponding convergence device by the gateway device, thereby implementing one-click networking and parameter configuration.

For specific limitations on the apparatus for generating the electrical topology diagram of the power system, reference may be made to the limitations on the method for generating the electrical topology diagram provided above, which will not be repeated here. Each module in the above apparatus for generating the electrical topology diagram of the power system may be implemented wholly or partially by software, hardware, or a combination thereof. The above modules may be embedded in or independent of a processor in a computer device in the form of hardware, or may be stored in a memory in the computer device in the form of software, such that the processor can call and execute operations corresponding to the above modules.

Specifically, the identification module, the first identification sub-module, and the second identification sub-module may be implemented by a processor configured to identify images. The generation module may be implemented by a processor configured to generate diagrams. The binding module may be implemented by a processor configured to bind information. The sending module may be implemented by a signal transmission device.

In an embodiment, a computer-readable storage medium is provided, having a computer program stored thereon. The computer program, when executed by a processor, implements the steps of the method for generating the electrical topology diagram of the power system in any one of the above embodiments.

Those skilled in the art can understand that all or part of the processes in the above method embodiments may be implemented by a computer program to instruct related hardware, and the program may be stored in a non-volatile computer-readable storage medium. The computer program, when executed, may implement all or part of the steps of the embodiments of the methods described above. Any reference to a memory, a database, or other media used in the embodiments provided in the present invention may include at least one of a non-volatile memory and a volatile memory. The non-volatile memory may include read-only memory (ROM), magnetic tape, floppy disk, flash memory, optical memory, and the like. The volatile memory may include a random access memory (RAM), an external cache memory, or the like. By way of illustration and not limitation, the RAM may be in various forms, such as a static random access memory (SRAM) or a dynamic random access memory (DRAM).

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present invention.

The above embodiments only illustrate several implementations of the present invention, and the description thereof is specific and detailed, but cannot therefore be understood as limiting the protection scope of the present invention. It should be noted that those of ordinary skill in the art may further make variations and improvements without departing from the conception of the present invention, and these all fall within the protection scope of the present invention. Therefore, the protection scope of the present invention should be subject to the appended claims.

## Claims

1. A method for generating an electrical topology diagram of a power system, **characterized in that** the power system comprises a plurality of direct current (DC) power supplies, a plurality of groups of power devices, and at least one convergence device, each of the plurality of groups of power devices is connected to corresponding one of the at least one convergence device, each of the plurality of groups of power devices comprises a plurality of power devices connected to at least one of the plurality of DC power supplies, respectively, and the method comprises:
identifying at least one information identification diagram corresponding to each of the at least one convergence device to obtain electrical topology location information and device information of each of power devices connected to each of the at least one convergence device, wherein the information identification diagram comprises at least one cell, and each of the at least one cell has a device identifier of corresponding one of the plurality of power devices and electrical topology location information of the one of the plurality of power devices; and
generating an electrical topology diagram of the power system based on the electrical topology location information and the device information of the power devices connected to each of the at least one convergence device.

2. The method of claim 1, wherein identifying the at least one information identification diagram corresponding to each of the at least one convergence device to obtain the electrical topology location information and the device information of each of the power devices connected to each of the at least one convergence device further comprises:
identifying a device identifier of each of power devices in each of the at least one information identification diagram to obtain the device information of the power devices; and
identifying row and column location information of a corresponding one of the at least one cell where each device identifier is located, and obtaining electrical topology location information of each of the power devices based on a mapping rule, wherein the mapping rule is configured to determine a one-to-one mapping relationship between the row and column location information of the at least one cell in the information identification diagram and the electrical topology location information of the power devices.

3. The method of claim 1, wherein generating the electrical topology diagram of the power system based on the electrical topology location information and the device information of the power devices connected to each of the at least one convergence device further comprises:
storing the device information and the electrical topology location information of each of the power devices in an information list in association with each other to obtain the electrical topology diagram.

4. The method of claim 1, wherein generating the electrical topology diagram of the power system based on the electrical topology location information and the device information of the power devices connected to each of the at least one convergence device further comprises:
generating an electrical topology block diagram of the power system based on the electrical topology location information of each of the power devices connected to each of the at least one convergence device; and
binding the device information of each of the power devices connected to each of the at least one convergence device with a corresponding power device in the electrical topology block diagram to obtain the electrical topology diagram.

5. The method of claim 1, wherein in a case where there are a plurality of convergence devices, generating the electrical topology diagram of the power system based on the electrical topology location information and the device information of the power devices connected to each of the at least one convergence device further comprises:
generating corresponding electrical topology relationship sub-diagrams based on the electrical topology location information and the device information of the power devices connected to each of the plurality of convergence devices; and
binding the corresponding electrical topology relationship sub-diagrams to obtain the electrical topology diagram of the power system.

6. The method of claim 1, further comprising:
acquiring at least one real-time device parameter of the power devices connected to each of the at least one convergence devices; and
binding the at least one device real-time parameter with either or both of electrical topology location information and device information of a corresponding power device in the electrical topology diagram.

7. The method of claim 1, further comprising:
sending the electrical topology diagram to a management module corresponding to each of the at least one convergence device to implement networking of the power devices.

8. The method of any one of claims 1 to 7, wherein the electrical topology location information at least comprises a group number of a corresponding group of power devices to which a corresponding power device belongs and a ranking of the corresponding power device in the group of power devices to which the corresponding power device belongs.

9. An apparatus for generating an electrical topology diagram of a power system, **characterized in that** the power system comprises a plurality of direct current (DC) power supplies, a plurality of groups of power devices, and at least one convergence device, each of the plurality of groups of power devices is connected to corresponding one of the at least one convergence device, each of the plurality of groups of power devices comprises a plurality of power devices connected to at least one of the plurality of DC power supplies, respectively, and the apparatus comprises an identification module and a generation module;
the identification module is configured for identifying at least one information identification diagram corresponding to each of the at least one convergence device to obtain electrical topology location information and device information of each of power devices connected to each of the at least one convergence device, wherein the information identification diagram comprises at least one cell, and each of the at least one cell has a device identifier of corresponding one of the plurality of power devices and electrical topology location information of the one of the plurality of power devices; and
the generation module is configured for generating an electrical topology diagram of the power system based on the electrical topology location information and the device information of the power devices connected to each of the at least one convergence device.

10. A computer-readable storage medium having a computer program stored thereon, **characterized in that** the computer program, when executed by a processor, implements steps of the method of any one of claims 1 to 8.
